Europäisches Patentamt

European Patent Office

Office européen des brevets

(19)

(11) Publication number: **0 327 994**

**A2**

(12) # EUROPEAN PATENT APPLICATION

(21) Application number: **89101897.0**

(51) Int. Cl.⁴: **H01H 43/02 , H01R 9/26**

(22) Date of filing: **03.02.89**

(30) Priority: **10.02.88 IT 8331388**

(43) Date of publication of application:
**16.08.89 Bulletin 89/33**

(84) Designated Contracting States:
**DE ES FR GB IT**

(71) Applicant: **EATON CONTROLS SpA**
**Via Vittor Pisani 31**
**I-20124 Milano(IT)**

(72) Inventor: **De Biasi, Virgilio**
**Via Nongole 166**
**I-32100 Belluno(IT)**
Inventor: **Scussel, Adriano**
**Via Nogarè 19c**
**I-32100 Belluno(IT)**
Inventor: **Baio, Alfonso**
**Via P.F.Calvi 12**
**I-32020 Limana (BL)(IT)**

(74) Representative: **Petraz, Gilberto Luigi**
**G.L.P. S.a.s. di Gilberto Petraz P.le Cavedalis**
**6/2**
**I-33100 Udine(IT)**

(54) **Modular programmer device with integrated interconnection to organize and transfer output contacts.**

(57) Modular programmer device (10) which comprises a plurality of modules (12a-12f) consisting of basic elements of pre-determined dimensions, one side (17) of each of the modules including a first row of a plurality of electrical output terminals (19) arranged in a first lateral zone (13a) and a second lateral zone (13b) respectively of that side (17), a third middle zone (14) of that side (17) being devoid of electrical terminals, the electrical output terminals (19) which belong to neighbouring pairs of modules (12a-12f) being separated from each other by a width of a first pre-determined pitch equal to the width of each of the modules (12a-12f), the device (10) comprising a first plate (22) for distribution and organization of electrical terminals which includes an upper face and a lower face, the lower face being positioned to cooperate with the electrical output terminals (19) and including a printed circuit (29) equipped with individual means (30-31-35) that cooperate with the electrical output terminals (19) and operate with the electrical output terminals (19) and also equipped with electrical connection tracks (33) and/or connection bridges (34) connected to the individual means (30-31-35), in which device (10) the electrical connection tracks (33) and/or the connection bridges (34) reorganize the arrangement of the electrical output terminals (19) on the upper face according to a first pre-determined plan including a plurality of first terminal means (15a-15c) organized in a number of second rows less than the number of modules (12a-12f) forming the device (10), the second rows being separated from each other by a distance of a second pre-determined pitch greater than, but not a finite multiple of, the first pitch, the first terminal means (15a-15c) being organized in groups within the second rows and being also organized according to a second pre-determined plan within such groups.

# EP 0 327 994 A2

fig.1

1a

## MODULAR PROGRAMMER DEVICE WITH INTEGRATED INTERCONNECTION TO ORGANIZE AND TRANSFER OUTPUT CONTACTS

This invention concerns a modular programmer device with integrated interconnection for the organization and transfer of the output contacts.

To be more exact, the invention concerns a programmer device which is advantageously but not essentially a programmer device for washing machines, ovens, etc. and in which the output terminals are organized in a coordinated manner with a standardized pitch.

Such output terminals thus become suitable to transfer signals by means of functional harnesses of wires, for instance by means of groups of wires side by side and organized for specific functions to be controlled and governed.

Owing to reasons linked to the reduction of costs, to the simplification of the processes for making harnesses of wires and to the need to obviate connection mistakes and to standardize the various components, the manufacturers of the appliances which employ such programmer devices have required for some time now that these devices should meet specific requirements as regards their output terminals.

It is known that these programmer devices comprise a plurality of elements assembled alongside each other; each element includes ·one or more output terminals connected to contacts which are actuated according to determined programmes by appropriate cams which are able to rotate about one single axis or about a plurality of axes.

The makers of the appliances employing such programmer devices have required for some time now that the output terminals should be organized in rows separated from each other by values which cannot be less than certain definite measurements so as to enable single connectors to be used for groups of output terminals.

These definite measurements are therefore determined by the minimum overall bulk of the multiple connectors employed and correspond to a minimum value greater than the present pitch of the output terminals of the programmer devices.

This minimum value varies between twelve and fourteen millimetres, whereas the present pitch of the output terminals of the programmer devices is about ten millimetres.

Moreover, the makers of the end-usage appliances require that each connection should cooperate with only one row of output terminals or a part of a row and that each connector should control and govern a specific function such as the motor, for instance.

Such requirements of the makers of the endusage appliances have the effect that the output terminals of the programmer devices as connected to the multiple connectors should comply with at least the following features:
- they should be organized for the functions to be governed and should be arranged in one single row of output terminals provided in the same order as that required during usage; in other words, the connector for connection to the specific output terminals of the programmer device and the connector for the specific input terminals of the end-usage appliance, the motor for instance, should have their input terminals and output terminals respectively in the same order;
- the output terminals should be separated in a row by minimum required values compatible with the pitch of the contacts in the multiple connectors;
- the rows should be separated by minimum values greater, in any event, than the thickness of the assembled elements, such minimum values being determined by the width of the multiple connectors;
- the connection plates should not exceed determined values in width and length.

These features mean that the output terminals as connected to the multiple connectors should be located in positions which in a plurality of cases do not coincide with the positions of the protrusion of the output terminals from the assembled module elements.

Moreover, the output terminals required in the programmer means may be greater in number than the output terminals which can be provided in the programmer means.

If it were desired to produce elements which had their output terminals already separated by values which were a multiple of the minimum values required between the lengthwise axes of the rows of output terminals, then many manufacturers would have to re-design all the programmer devices. This would entail high costs and, above all, risks due to too restricted interspaces.

Furthermore, the manufacturers of the end-usage appliances tend to load auxiliary functions onto the programmer devices so as to simplify their connecting circuits. The contacts therefore, have to be able to withstand more and more intense currents and an ever greater number of actuations.

This means that the electrical connections have to be free of dispersion and losses of load as much as possible. If this were not so, the electrical connections would overheat and would cause the contacts and output terminals too to overheat.

An embodiment is known which includes a programmer device with output terminals arranged at the sides of a lateral face of the device. These output terminals, for organizational purposes, are connected with electrical wires including wound eyelets which are pressed onto substantially cylindrical output terminals.

This embodiment entails a plurality of drawbacks. It does not accept rows of output terminals separated by values different from multiples of the thicknesses of the assembled elements, nor does it accept multiple single connectors; it accepts only one single multiple box-type honeycomb housing.

In the event of high loads of current and/or frequent interruptions the connections generate heat with obvious risks of overheating and breakage of the connections themselves.

The present applicant has designed, tested and embodied this invention to obviate the above drawbacks and to provide a plurality of advantages which will be made clear in the following description.

The present invention is therefore embodied with a programmer device having integrated interconnections for the organization and transfer of output contacts, the device possessing the features of Claim 1, while the dependent claims define preferred forms of embodiment of the invention.

According to a general lay-out of the invention the traditional output terminals are included on the programmer device, to be more exact on one side face thereof.

The traditional output terminals are embodied in two different forms; the terminals located in the end rows may be the normal connecting strip terminals or connecting pin terminals. The pin terminals are less tall than the strip terminals.

The output terminals which are located not only in the end rows but are also in the specific selected rows are connecting strip terminals.

The traditional output terminals which are not in the end rows nor in the exact required position in those rows will be, instead, pin terminals.

The traditional output terminals are positioned along the two lengthwise sides of the lateral face of the programmer device, and therefore each of the assembled module elements will have its traditional output terminals arranged on the two sides of a specific face.

Each element will therefore have the required number of traditional output terminals on the two sides of a specific face.

Depending on the cases mentioned above, these traditional output terminals will be in the form of connecting strip terminals or connecting pin terminals.

In one of these elements the traditional output terminals may consist of connecting strip terminals alone or of connecting pin terminals alone or of strips and pins together.

Printed circuits are provided in cooperation with these traditional output terminals and reorganize the latter, making it possible to include them in organized rows either as abscissae or ordinates.

These printed circuits serve also to organize the output terminals in groups in the required order and in the required sequence in each group.

The printed circuits, which are personally adapted to the requirements of the manufacturer of the end-usage appliances, cooperate with the traditional output terminals, whether the latter be connected strip terminals or connecting pin terminals.

Moreover, the printed circuits comprise their own connecting strip terminals to complete the rows so as to include output terminals which are all usable with their own connecting strips.

The printed circuits may include connecting strip terminals also outside the edge of the programmer device.

We have spoken so far and will speak hereinafter of connecting strip terminals as meaning not one definite form but any form of terminal (fork, pin, grooved pin, lamina, etc.) which is suitable to provide a desired connection as arranged in the multiple terminal boards of the individual connectors.

The printed circuit will be arranged advantageously as a standardized grill with connection bridges to couple the permanent contact conductors surrounding the holes in the printed circuit, in conjunction with the connecting strip terminal or connecting pin terminal, to the connection tracks disposed about the permanent contact conductors.

The printed circuit may be of a type made of sheet or strip, sheared or punched, or of a type made by photoengraving or like systems on copper plate on an insulating support, or of a type made by photodeposition on an insulating support, or of any type suitable for the purpose.

By interrupting suitably one or more of the connection bridges between the various permanent contact conductors and any connection tracks between such bridges or between the permanent contact conductors, it is possible to personalize in a required manner the transfer of signals, so as to have the signals in the required row in the desired group of terminals in the required order.

The printed circuits may also be produced originally as personalized printed circuits and in this case it will only be necessary to interrupt mechanical bridges when installed or during installation.

Moreover, these personalized printed circuits can also have the connection terminals included in the circuit of which such terminals form part, and not added subsequently.

For the sake of simplicity we shall deal hereinafter only with printed circuits which have to be personalized and to which the connection terminals have to be fitted by rivetting or brazing or soldering or another suitable system.

According to a variant a printed circuit, which is personalized or requires personalization, may be provided in a space free of traditional contacts and in the middle between the two lateral sets of traditional contacts whenever the transfers are such and of such complexity as to make necessary a further division of the transfer circuits.

According to another variant two or more printed circuits, already personalized or to be personalized, may be included in cooperation with each other.

The printed circuits may be wholly or partly sunk in a sandwich consisting of organized plastic plates having insulation functions.

The attached figures, which are given as a non-restrictive example, show the following:-

Fig. 1 shows a broken-down view of the components of a programmer device according to the invention;

Fig.2 shows a broken-down view of the plates forming the personalized printed circuits relating to Fig.1;

Fig.3 shows from above a possible printed circuit which has not been personalized;

Fig.4 gives a three-dimensional broken-down view of part of two personalized printed circuits;

Fig.5 gives a three-dimensional cutaway view of a part of a row of organized output terminals;

Fig.6 gives a three-dimensional cutaway view of a set of rows of output terminals;

Fig.7 shows a section of a variant with auxiliary lateral terminals and two printed circuits;

Fig.8 shows a section or a further variant with an auxiliary circuit.

In the figures a programmer device 10 shown broken-down into parts is suitable to be employed in end-use appliances and is embodied according to one lay-out of the invention.

This innovatory programmer device 10 employs a programmer device 11 which comprises on one lateral face 17 a middle zone 14 devoid of electrical output terminals 19 and two lateral zones 13 in which the electrical output terminals 19 are located.

The electrical output terminals 19 may be one or more in number per each lateral zone 13 and per each base element or module 12; each module 12 therefore comprises one row of electrical output terminals 19.

The plurality of the base elements or modules 12 with the respective internal cams and a motor unit 20 and headstock form the basic programmer device 11.

In the example shown the distance between the rows of output terminals to meet the requirements of the end-user is made equal to one and a half times the thickness of the base elements or modules 12 assembled together.

In the case of the present applicant the base elements or modules 12, when assembled, have a thickness of 10 mm., and therefore the rows are arranged with 15 mm. between the lengthwise axis of one row and that of the next row or the previous row.

Hence in the case of the example shown and of the programmer device 11 the base elements or modules 12a and 12d are separated, as a median value, by a module distance 18 of 30 mm.

Therefore the base element or module 12a has the connecting strip terminals, or tabs, 15a protruding already from the base element or module 12a itself.

To simplify the situation, the example given shows a case in which all the electrical output terminals 19 of the base element or module 12a consist of connecting strip terminals or tabs 15a.

What we have said regarding the base element or module 12a is applicable also to the base element or module 12d separated from the module 12a by two base elements or modules 12b and 12c respectively, the module 12d being followed by two base elements or modules 12e and 12f respectively.

In this way, while keeping the distance between the rows of output terminals slightly greater than the required minimum value, which may be between 11 mm. and 14 mm. between the lengthwise axis of one row of output terminals and another, it is possible to employ base elements or modules 12 of the type normally produced with a thickness of 10 mm. when installed.

The electrical output terminals 19 on the intermediate base elements or modules 12b, 12c, 12e and 12f respectively will be formed as connecting pin terminals 16.

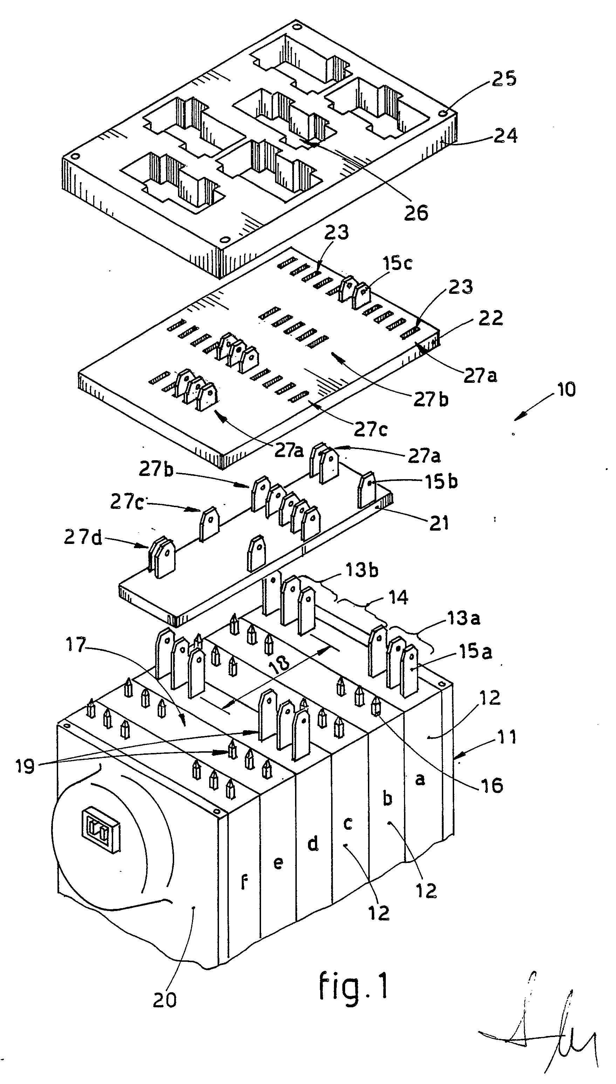

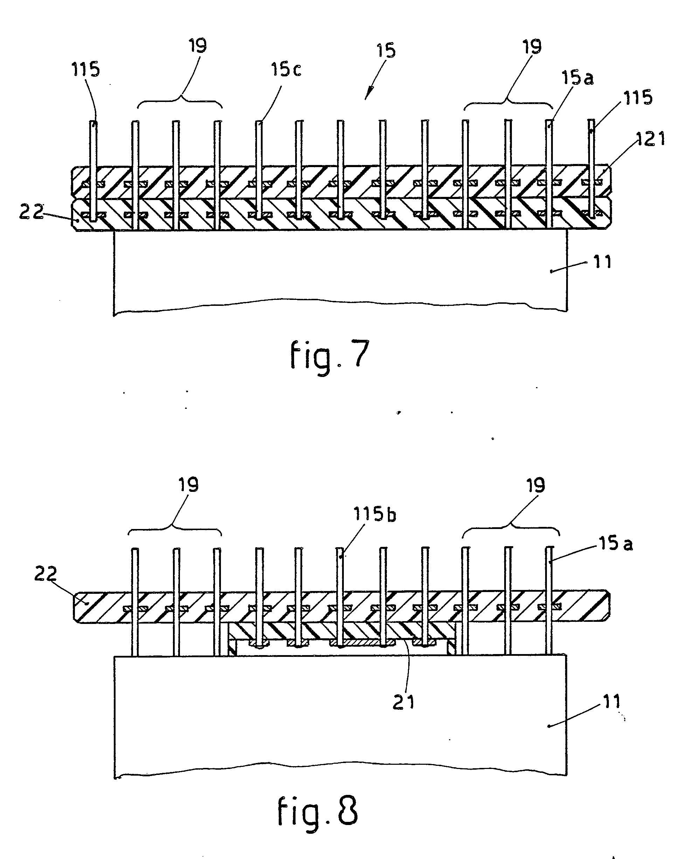

In the example of Figs.1 and 8 the empty middle zone 14 is used to fit or position a distribution plate 21, which is employed when an organization and distribution plate 22 that will be described in more detail hereinafter is not enough for the proper organization and transfer of the output terminals 15.

It should be borne in mind that the output terminals 15 according to the invention are placed in groups, each of which is located in one row, and the output terminals 19 are arranged in a standardized manner in the groups.

The distribution plate 21 may, or may not, comprise one or more output terminals 15b or suitable coordination seatings as in Fig.8. Such output terminals 15b are spaced apart by the standardized value and are organized in standard groups in the output terminal rows 27.

In the example of Fig.1 the output terminals in the distribution plate 21 are all of the connecting strip terminal or tab type 15b and form the middle tract of the rows 27 of output terminals.

Each row of the individual rows 27 on the distribution plates 21 may, or may not, comprise all the connecting strip terminals or tabs 15b required for the transfer in progress.

In the example shown we have envisaged for teaching purposes that the distribution plate 21 comprises four organized rows 27 of output terminals and that a maximum of five connecting strip terminals 15b can be provided in each row.

In the case shown the portion of row 27a comprises two of such terminals 15b, two empty spaces and then another terminal 15b; the portion of row 27b comprises all five such terminals 15b; the portion of row 27c comprises two terminals 15b at the sides, while the portion of row 27d comprises two terminals 15b on one side.

An organization and distribution plate 22 is placed above the distribution plate 21 and cooperates with the electrical output terminals 19 on the lateral face 17 or with the connecting strip terminals 15b on the distribution plate 21.

The organization and distribution plate 22 may also include terminals 115 outside the programmer device 11.

The organization and distribution plate 22 has the rows 27 complete.

The rows 27 of output terminals may include, as in the example shown, transit holes 23 through which pass connecting strip terminals 15a and 15b or 15c, or smaller connecting pin terminals 15 (Fig.8) for electrical connection to the distribution plate 21.

In the example shown in Figs.1, 2 and 8 the rows 27a and 27c comprise eleven organized output terminals, whereas rows 27b and 27d comprise five organized output terminals.

In the example of Fig.7 the rows 27a and 27c comprise thirteen organized output terminals.

The five middle output terminals of rows 27a and 27c are aligned with the output terminals of rows 27b and 27d and, in this example, cooperate with the distribution plate 21 or with the distribution plate 121 of Fig.7.

Thus, for instance, the output terminal row 27a will have its first three connection terminals 15 consisting of the connecting terminals 15a of the lateral space 13a, its fourth, seventh and eighth connection terminals 15 consisting of the connecting terminals 15b of the portion of row 27a of the distribution plate 21 and its last three connection terminals 15 consisting of the connecting terminals 15a of the lateral space 13b.

Therefore, at the beginning each connecting terminal 15a, 15b and 15c will have a different height so that, when the whole assembly has been fitted together, all the connecting terminals 15a, 15b and 15c will constitute connection terminals 15 protruding by the same height from the organization and distribution plate 22.

A cover plate 24 is fitted above the organization and distribution plate 22 and comprises possible fixture holes 25 and holes 26 for introduction of multiple connectors which organize visually the segments of rows 27 in groups coordinated in relation to specific working functions, each group containing output terminals arranged as required in the specific end-usage appliances governed by that specific group.

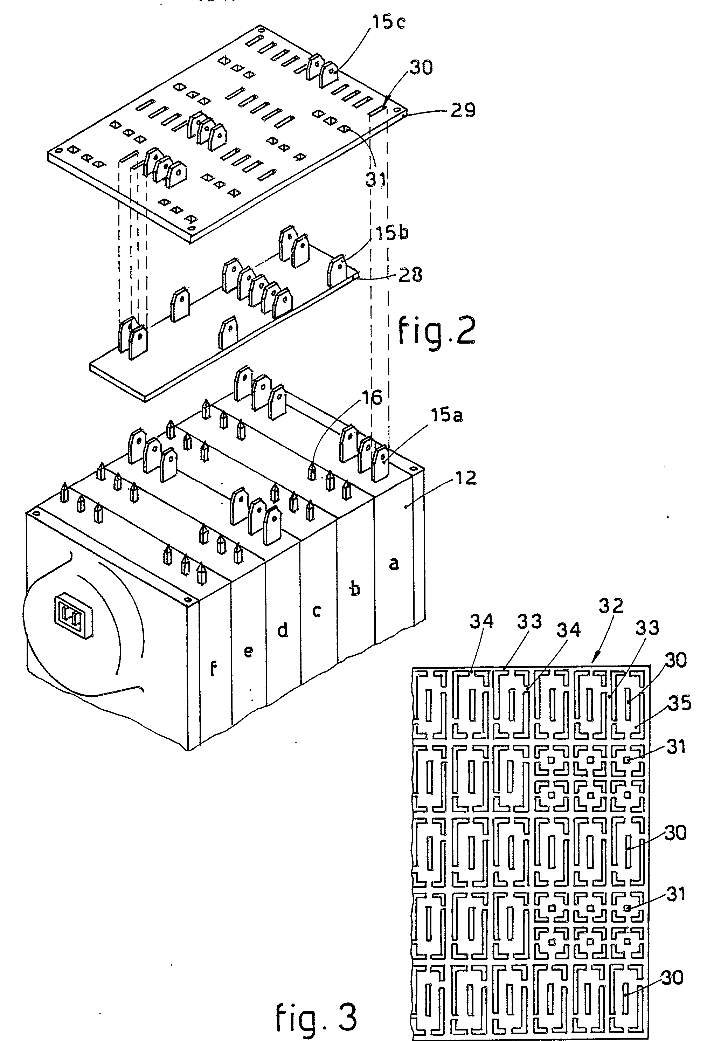

Fig.2 gives a broken-down view of the invention wherein the distribution plate 21 and the organization and distribution plate 22 are seen without their insulation covering and are shown as personalized printed circuits 28 and 29 respectively.

The second personalized printed circuit 29 comprises not only first connection holes 30 coinciding with through holes 23 in the organization and distribution plate 22 but also second connection holes 31 suitable to cooperate with the connecting pin terminals 16.

Fig.3 shows partially an example of a standardized grill 32 suitable to provide the printed circuits 29.

In Fig.3 can be seen the first connection holes 30 and also the the second connection holes 31, each hole being surrounded by its own permanent contact conductor 35. The permanent contact conductors 35 are connected to electrical connection tracks 33 by connection bridges 34.

First and second personalized printed circuits 28-29 are obtained by interrupting the connection tracks 33 and connection bridges 34 suitably.

Printed circuits of any other type can be used instead of the above system.

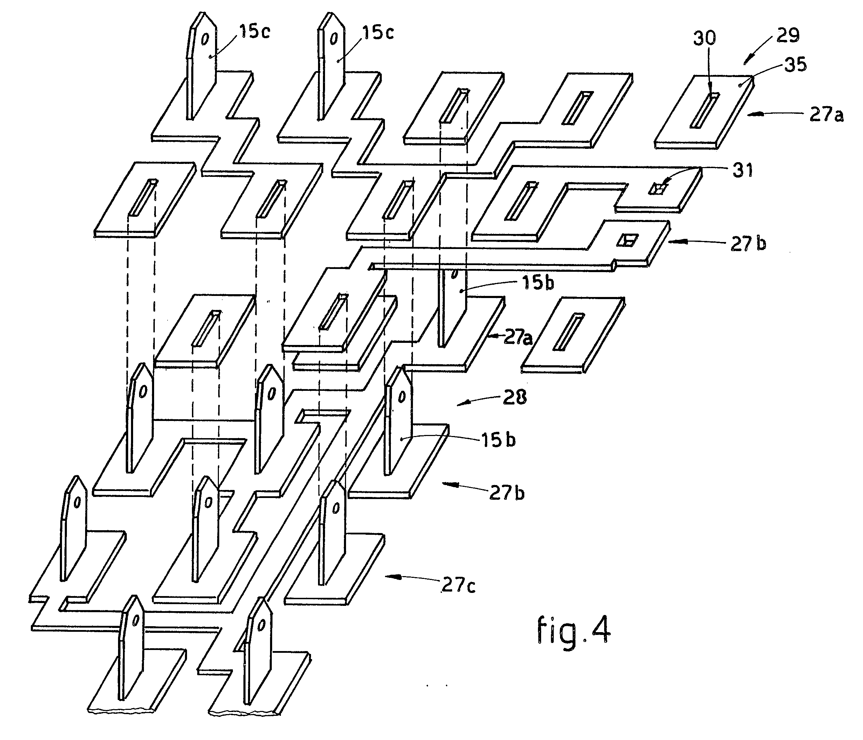

Fig.4 shows parts of the first and second printed circuits 28 and 29 respectively which have been personalized to illustrate the invention. In this figure can be seen the permanent contact conductors 35 with their respective first connection holes 30 and second connection holes 31 and the connecting strip terminals or tabs 15b and 15c, the whole assembly being broken down as on an assembly line.

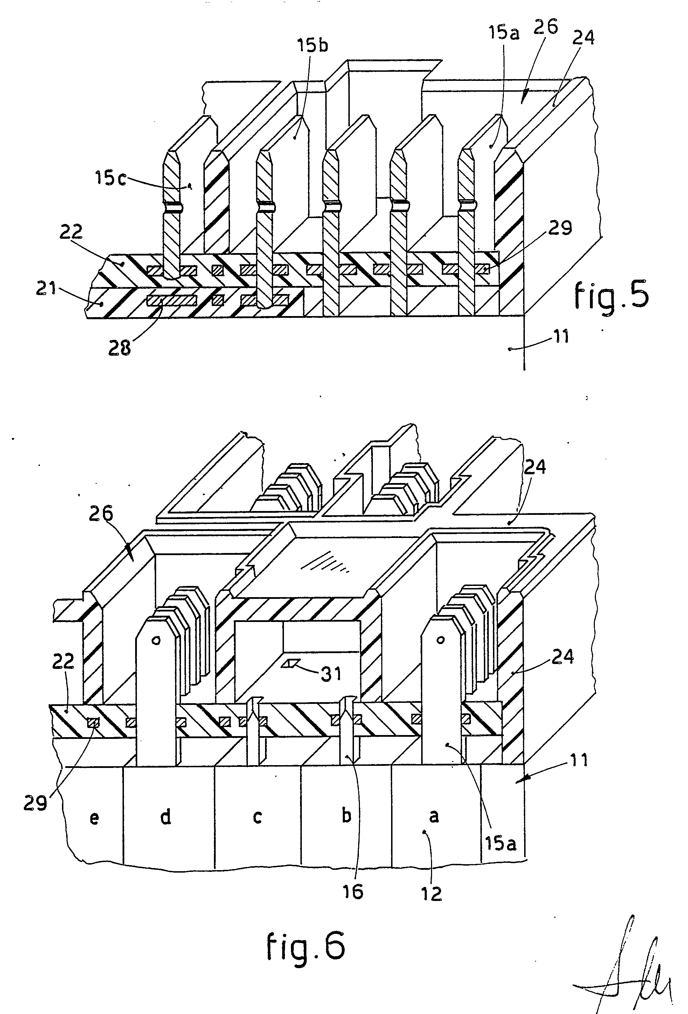

Fig.5 shows partly a three-dimensional view and partly a section view of a lengthwise section along the axis of a row 27; in this example the row 27 could equally well be the row 27a or the row 27c.

The organized output terminals delimited by holes or seatings 26 in which the multiple connectors are lodged can be seen.

The figure shows also the connecting strip terminals or tabs 15a, 15b and 15c respectively, their method of cooperating with the distribution plate 21 and with the organization and distribution plate 22 and their connection with the first connection holes 30.

The first connection holes 30 and second connection holes 31 may have any shape able to improve electrical connection to the output strip terminals 15 and pin terminals 16.

The strip terminals 15 and pin terminals 16 too may have conformations suitable to improve electrical connection.

Thus the the first connection holes 30 and second connection holes 31 may have their edge pointed, their vertical walls sloped, their lateral walls corrugated, etc.

Likewise, the strip terminals or tabs 15 and the pin terminals 16 may include swollen portions, corrugations, protrusions, fins, etc.

The personalized printed circuits 28-29 of Figs.5 and 6 are wholly enveloped with a plastic insulation material so as to constitute the respective distribution plate 21 and organization and distribution plate 22.

The distribution plate 121 of Fig.7 is positioned above the organization and distribution plate 22.

## Claims

1 - Modular programmer device (10) which comprises a plurality of modules (12a-12f) consisting of basic elements of pre-determined dimensions, one side (17) of each of the modules including a first row of a plurality of electrical output terminals (19) arranged in a first lateral zone (13a) and a second lateral zone (13b) respectively of that side (17), a third middle zone (14) of that side (17) being devoid of electrical terminals, the electrical output terminals (19) which belong to neighbouring pairs of modules (12a-12f) being separated from each other by a width of a first pre-determined pitch equal to the width of each of the modules (12a-12f), the device (10) being characterized by a first plate (22) for distribution and organization of electrical terminals which includes an upper face and a lower face, the lower face being positioned to cooperate with the electrical output terminals (19) and including a printed circuit (29) equipped with individual means (30-31-35) that cooperate with the electrical output terminals (19) and also equipped with electrical connection tracks (33) and/or connection bridges (34) connected to the individual means (30-31-35), in which device (10) the electrical connection tracks (33) and/or the connection bridges (34) reorganize the arrangement of the electrical output terminals (19) on the upper face according to a first pre-determined plan including a plurality of first terminal means (15a-15c) organized in a number of second rows less than the number of modules (12a-12f) forming the device (10), the second rows being separated from each other by a distance of a second pre-determined pitch greater than, but not a finite multiple of, the first pitch, the first terminal means (15a-15c) being organized in groups within the second rows and being also organized according to a second pre-determined plan within such groups.

2 - Device (10) as claimed in Claim 1, in which a second distribution plate (21) is positioned between the plurality of modules (12, 12f) and the first plate (22) and is located within the third middle zone (14) and comprises second terminal means (27) which are organized in third rows separated by a distance equal to the second pre-determined pitch and which cooperate with the individual cooperation means (30-31-35) borne on the first plate (22).

3 - Device (10) as claimed in Claim 2, in which the first plate (22) and the second plate (21) are at least partly lined with an insulation material and comprise fixture means.

4 - Device (10) as claimed in any claim hereinbefore, in which a third cover plate (24) is located above the first organization and distribution plate (22) and comprises seatings (26) to lodge multiple connectors, the seatings (26) being arranged in the third plate (24) according to the first pre-determined plan, each of the seatings (26) delimiting one of the groups of first terminal means (15a-15c) within the second rows of first terminal means (15a-15c) on the first organization and distribution plate (22).

5 - Device (10) as claimed in any claim hereinbefore, in which the individual means (30-31-35) which cooperate with the electrical output terminals (19) consist at least partly of first connection holes (30) and second connection holes (31) and of permanent contact conductors (35).

6 - Device (10) as claimed in Claim 5, in which a part of the electrical output terminals (19) passes through the the first connection holes (30) and second connection holes (31) and extends above the upper face of the organization and distribution plate (22) to form a part (15a) of the first terminal means (15a-15c).

7 - Device (10) as claimed in Claim 5 or 6 together with Claim 2, in which at least a part of the second terminal means (27) borne by the second distribution plate (21) passes through the first connection holes (30) and the second connection holes (31) and extends above the upper face of the first organization and distribution plate (22) to form a part (15b) of the first terminal means (15a-15c).

8 - Device (10) as claimed in any claim hereinbefore, in which the first terminal means (15a-15c) extend above the upper face of the first organization and distribution plate (22) by a pre-determined length.

9 - Device (10) as claimed in any claim hereinbefore, in which the electrical output terminals (19) protruding from the lateral face (17) of each of the modules (12a-12f) are structured with the form of connecting strips and/or connecting pins.

10 - Device (10) as claimed in any of Claims 2 to 9 inclusive, in which the second terminal means (27) borne by the second distribution plate (21) are structured with the form of connecting strips and/or pins and/or sleeves.

11 - Device (10) as claimed in Claim 10, in which a part (15c) of the first terminal means (15a-15c) extends between the upper face and lower face of the first organization and distribution plate (22) and forms within the third middle zone (14) connecting pins able to cooperate with the sleeves borne by the second distribution plate (21).

fig.1

fig.2

fig. 3

fig. 4

fig.5

fig.6

fig. 7

fig. 8